# EUROPÄISCHE PATENTSCHRIFT

(11) **EP 1 558 782 B1**
(45) Veröffentlichungstag und Bekanntmachung des Hinweises auf die Patenterteilung: **29.03.2006**
(21) Anmeldenummer: 03795784.2
(22) Anmeldetag: 15.10.2003
(51) Int. Cl.: C23C 14/28, C23C 14/24

(54) **VORRICHTUNG UND VERFAHREN ZUM AUFDAMPFEN EINES HOCHTEMPERATURSUPRALEITERS IM VAKUUM MIT KONTINUIERLICHER MATERIALNACHFÜHRUNG**
DEVICE AND METHOD FOR THE EVAPORATIVE DEPOSITION OF A HIGH-TEMPERATURE SUPERCONDUCTOR IN A VACUUM WITH CONTINUOUS MATERIAL INTRODUCTION
DISPOSITIF ET PROCEDE DE DEPOT EN PHASE VAPEUR SOUS VIDE D'UN SUPRACONDUCTEUR À HAUTE TEMPÉRATURE AVEC REMPLISSAGE DE MATÉRIAU AUTOMATIQUE

(30) Priorität: 05.11.2002 EP 02024901
(43) Veröffentlichungstag der Anmeldung: 03.08.2005
(73) Patentinhaber: Theva Dünnschichttechnik GmbH, 85737 Ismaning (DE)
(72) Erfinder: KINDER, Helmut, 85354 Freising (DE)
(74) Vertreter: Hess, Peter K. G.
(86) Internationale Anmeldenummer: PCT/EP2003/011428
(87) Internationale Veröffentlichungsnummer: WO 2004/041985

(56) Entgegenhaltungen:
- WO-A-98/22635
- DE-A- 2 513 813
- US-A- 3 654 109
- US-A- 4 381 894
- US-A- 5 254 832
- PATENT ABSTRACTS OF JAPAN vol. 013, no. 331 (C-622), 25. Juli 1989 (1989-07-25) & JP 01 108364 A (ISHIKAWAJIMA HARIMA HEAVY IND CO LTD), 25. April 1989 (1989-04-25)
- PATENT ABSTRACTS OF JAPAN vol. 013, no. 331 (C-622), 25. Juli 1989 (1989-07-25) & JP 01 108363 A (ISHIKAWAJIMA HARIMA HEAVY IND CO LTD), 25. April 1989 (1989-04-25)
- PATENT ABSTRACTS OF JAPAN vol. 010, no. 144 (C-349), 27. Mai 1986 (1986-05-27) & JP 61 003880 A (TAIYOU YUUDEN KK), 9. Januar 1986 (1986-01-09)
- DAVIS M F ET AL: "ELECTRON BEAM FLASH EVAPORATION FOR YBACUO AND BICASRCUO THIN FILMS" JOURNAL OF APPLIED PHYSICS, AMERICAN INSTITUTE OF PHYSICS. NEW YORK, US, Bd. 66, Nr. 10, 15. November 1989 (1989-11-15), Seiten 4903-4908, XP000105104 ISSN: 0021-8979 in der Anmeldung erwähnt
- PATENT ABSTRACTS OF JAPAN vol. 014, no. 022 (E-874), 17. Januar 1990 (1990-01-17) & JP 01 264114 A (SUMITOMO ELECTRIC IND LTD), 20. Oktober 1989 (1989-10-20)
- PATENT ABSTRACTS OF JAPAN vol. 1997, no. 08, 29. August 1997 (1997-08-29) & JP 09 095775 A (CHUGAI RO CO LTD), 8. April 1997 (1997-04-08)
- LEE S-G ET AL: "DEPOSITION ANGLE-DEPENDENT MORPHOLOGY OF LASER DEPOSITED YBA2CU3O7 THIN FILMS" APPLIED PHYSICS LETTERS, AMERICAN INSTITUTE OF PHYSICS. NEW YORK, US, Bd. 65, Nr. 6, 8. August 1994 (1994-08-08), Seiten 764-766, XP000464593 ISSN: 0003-6951
- PATENT ABSTRACTS OF JAPAN vol. 1999, no. 08, 30. Juni 1999 (1999-06-30) & JP 11 086647 A (FUJIKURA LTD), 30. März 1999 (1999-03-30)

## Beschreibung

### 1. Technisches Gebiet

Die vorliegende Erfindung betrifft eine Vorrichtung und ein Verfahren zum Aufdampfen eines Hoch temperatursupraleiters im Vakuum, insbesondere zur Herstellung von Beschichtungen aus komplexen anorganischen Verbindungen wie Hochtemperatursupraleitern.

### 2. Der Stand der Technik

Dünne Schichten aus komplexen anorganische Verbindungen, z.B. aus Oxiden, Nitriden, Carbiden oder Legierungen verschiedener Kationen, dienen in vielen Anwendungen der Elektronik, Optik oder des Maschinenbaus als Funktionsschichten oder Oberflächenvergütungen. So werden zum Beispiel Schichten aus PZT (Blei-Zirkonat-Titanat) - Keramiken oder BaTiO₃ für ferroelektrische Sensorelemente oder als Datenspeicher mit hoher Dielektrizitätskonstante eingesetzt. Dünne epitaktische Schichten aus RBa₂Cu₃O₇ (R = Yttrium oder ein Element der seltenen Erden) werden bei tiefen Temperaturen supraleitend und können z.B. in der Kommunikationstechnik für trennscharfe Hochfrequenzfilter oder aufgebracht auf flexiblen Metallbändem als verlustlose Stromleiter eingesetzt werden.

Für den wirtschaftlichen Einsatz müssen für viele dieser Anwendungen große Flächen oder große Längen (Bandleiter) in möglichst kurzer Zeit beschichtet werden. Da viele Verbindungen die gewünschten Eigenschaften nur bei hoher kristalliner Perfektion der Schicht zeigen, werden an die Beschichtungstechnik hohe Anforderungen gestellt. Bei Mischverbindungen muss zudem die korrekte stoichiometrische Zusammensetzung über die gesamte Beschichtungsfläche und die gesamte Dauer der Beschichtung gewährleistet sein.

In der Regel werden zur Beschichtung Vakuumbeschichtungsverfahren wie Sputtern, Laserablation (PLD), chemische Gasphasenabscheidung (CVD), Molekularstrahlepitaxie (MBE) oder Verdampfen angewandt. Für Techniken, die von keramischen, nichtleitende Verbindungen (Targets) ausgehen, (z.B. Sputtern, PLD) ist die Volumenabscheiderate meist sehr gering. Techniken wie CVD oder Koverdampfen, wie zum Beispiel in EP 0 282 839 B1 beschrieben, benutzen einzelne Materialquellen, deren Materialflüsse individuell mit Hilfe einer komplexen Regelung gesteuert werden müssen. Da die Materialien zudem nicht aus einer Punktquelle stammen bzw. empfindlich auf lokale physikalische Abscheideparameter wie Substrattemperatur oder Gasdruck reagieren, kommt es auf großen Flächen trotzdem zu Schwankungen in der Zusammensetzung der Schicht.

Das ideale Beschichtungsverfahren würde mit einer Punktquelle arbeiten, aus der das Material in der richtigen Zusammensetzung mit hohem Materialfluss austritt und sich homogen auch über größere Entfernungen ausbreitet und auf großer Fläche abscheidet. Dieses Ideal ist mit dem Elektronenstrahlverdampfen, bei dem ein hochenergetischer Elektronenstrahl das Zielmaterial extrem erhitzt und zum Verdampfen bringt, in guter Näherung erfüllt. Dieses Verfahren wird deshalb in vielen technischen Beschichtungsprozessen für einfache Verbindungen oder Elemente wie z.B. für Aluminium für Reflektoren oder Verpackungsfolien oder einfache Oxide für optische Oberflächenvergütungen eingesetzt. Problematisch ist jedoch das Verdampfen von Materialmischungen mit stark unterschiedlichen Dampfdrücken der Einzelkomponenten oder Verbindungen, die bei Elektronenbeschuss chemisch zerstört werden (cracken) oder fraktionieren.

In JP 0 12 64 114 A ist ein solches Verfahren für die Abscheidung von Hochtemperatursupraleiterfilmen beschrieben. Die damit erreichten Ergebnisse sind jedoch mangelhaft. Werden nämlich derartige Mischungen oder Verbindungen aus einem einzelnen Tiegel verdampft, so tritt Fraktionierung auf und auf Grund der ständig wechselnden lokalen thermischen Verhältnisse ändert sich im zeitlichen Verlauf die Zusammensetzung der abgedampften Materialien. Diesem Problem kann man durch schnelle Ablenkung des Elektronenstrahls in mehrere, voneinander unabhängige Tiegel, und die jeweilige Verweildauer des Elektronenstrahls begegnen. Allerdings nimmt man damit wieder die Nachteile in Kauf, die durch Verwendung mehrerer lokal getrennter Einzelquellen entstehen, nämlich Gradienten der Zusammensetzung auf größeren Flächen.

Alternativ wurde deshalb zur Herstellung von Legierungsbeschichtungen in der JP 6 11 95 968 A ein Verfahren beschrieben, bei dem die Legierungsbestandteile in verschieden großen, sektorförmigen Taschen einer rotierbaren Verdampferquelle eingebracht werden. Durch schnelles Rotieren unter einem feststehenden Elektronenstrahl kann auch auf diese Weise im zeitlichen Mittel die gewünschte Zusammensetzung aus einem Punkt verdampft werden. Problematisch bei dieser Anordnung ist jedoch, dass die Kapazität der Tiegel begrenzt ist und eine kontinuierliche Nachfüllung auf Grund der Rotation nicht in Frage kommt. Das Verfahren eignet sich deshalb nicht für eine kontinuierliche Langzeitbeschichtung, bei der große Materialmengen benötigt werden. Dasselbe gilt für ähnliche Vorrichtungen mit rotierbaren Elektronenstrahl-Verdampferquellen wie der in JP 20 02 097 566 A beschriebenen, die das selektive Verdampfen verschiedener Materialien ermöglichen oder der in JP 02 294 479 A beschriebenen Anordnung, die das "Eingraben" des Elektronenstrahls verhindert und eine gleichbleibende frische Oberfläche des Verdampfungsguts garantiert.

Für die kontinuierliche Produktion kommt dem Materialnachschub entscheidende Bedeutung zu. Für statische Verdampfertiegel sind derartige Nachfiilleinrichtungen z.B. aus JP 61 003 880 A bekannt. Das Verdampfen aus einem statischen Tiegel oder das allmähliche Verdampfen selbst aus einem sich bewegenden Tiegel führt bei komplexen Verbindungen, wie z.B. oxidischen Hochtemperatursupraleitern, auf Grund von Fraktionierung zu Problemen mit der chemischen Zusammensetzung der Beschichtung. Die Ursache liegt darin, dass im Verdampfertiegel kein Gleichgewicht erreicht wird, da sich lokal die thermischen und chemischen Verhältnisse ständig ändern.

Ein Ausweg ist das sogenannte "Flashverdampfen" einzelner Materialkömer. Dadurch werden nacheinander jeweils kleine Portionen (Körner) des zu verdampfenden Materials quantitativ, d. h. im wesentlichen ohne Rückstand, verdampft. Dadurch wird erzwungen, dass der Dampf im zeitlichen Mittel über einige Körner dieselbe Zusammensetzung wie das Verdampfungsmaterial aufweist. Allgemeiner gesprochen kommt es beim quantitativen Verdampfen aber gar nicht so sehr darauf an, dass eine Materialportion quasi instantan verdampft wird, sondern vonviegend darauf, dass sich in der Verdampfungszone ein Gleichgewicht zwischen dem Verdampfen durch den Elektronenstrahl und der ständigen Materialzufuhr einstellt.

Ein erster Ansatz für diese Art der Verdampfung wurde von Davis et al. im J. Appl. Phys. 66, (1989) 4903, beschrieben. Die Autoren versuchten, oxidische Supraleiterschichten herzustellen, indem sie eine dünne Linie (Spur) aus Pulver des jeweiligen Aufdampfinaterials mit dem Elektronenstrahl von vome nach hinten abtrugen. An der heißen Front sollten ständig einzelne Pulverkömer in Sekundenbruchteilen verdampft werden. Die Resultate dieser Versuche waren jedoch unbefriedigend. Da das pulverisierte Ausgangsmaterial eine große innere Oberfläche aufweist und z.T. sogar hygroskopisch ist, befindet sich sehr viel adsorbiertes Wasser an den Körnern. Beim starken Aufheizen verdampft dieses schlagartig und sprengt die Pulverkörner auseinander, so dass sie aus der Verdampfungszone geschleudert statt in die Gasphase überführt werden. Aus diesem Grund wurde ein zweistufiges Verfahren angewandt. In einem ersten Schritt wurde das Pulver durch den erheblich schwächer eingestellten Elektronenstrahl entgast und das Pulver zu kleinen Tröpfchen aufgeschmolzen. Im zweiten Schritt wurde versucht, diese Tröpfchen durch Flashverdampfen in die Gasphase zu überführen.

Davis et al. verwendeten das Flashverdampfen dabei in Kombination mit einem weiteren Verfahrenschritt zur Herstellung der Hochtemperatur-Supraleiter, indem sie zuerst das Material auf die erläuterte Weise im Hochvakuum verdampften und danach das amorph abgeschiedene Material in Sauerstoff-Umgebung rekristallisierten, indem sie entweder eine Heizvorrichtung in der Aufdampfkammer bei vermindertem Sauerstoffdruck verwendeten ("in situ") oder einen Ofen mit Sauerstoff bei Atmosphärendruck ("ex situ").

Auf Grund der oben erläuterten Prozessführung von Davis et al. beim Flashverdampfen ist unmittelbar klar, dass das Verfahren nicht für größere Materialmengen oder gar kontinuierlichen Betrieb in Frage kommt. Zudem verschiebt sich der Verdampfungspunkt laufend entlang der Spur. Darüber hinaus stellte sich jedoch heraus, dass die Tröpfchen mit ca. 0,1 g Gewicht bereits zu groß waren, um instantan in die Gasphase überführt zu werden. Konzentrationstiefenprofile der durch das Verdampfen eines Tröpfchens hergestellten Schicht - in diesem Fall YBa₂Cu₃O₇ - zeigen ausgeprägte Fraktionierung mit einer starken Ba - Anreicherung an der Filmoberfläche. Die Filme müssen deshalb thermisch nachbehandelt werden und sind selbst danach von schlechter Qualität.

Die Patentschrift DE 25 13 813 A beschreibt eine Vorrichtung und ein Verfahren zur kontinuierlichen Beschichtung von Kunststoffen, insbesondere von Gläsern, mit anorganischem Glas. Hierzu wird eine Vorrichtung verwendet, die aus einem Schmelztiegel mit einer Vertiefung besteht. Aus einem Trichter wird über eine Rutsche ein gekörntes Beschichtungsmaterial in die Vertiefung eingebracht, welches nach Drehen in die Verdampfungszone mit Hilfe eines Elektronenstrahls vollständig verdampft wird.

JP01108364 und JP01108363 beschreiben ebenfalls Elektronenstrahlverdampfer und Verdampfungsverfahren mit kontinuierlicher Materialnachführung unter Verwendung eines Drehtellers.

Der vorliegenden Erfindung liegt daher das Problem zugrunde, eine Vorrichtung und ein Verfahren zum Aufdampfen eines Hochtemperatursupraleiters auf einem Substrat bereitzustellen, das einerseits mit hohen Raten wirtschaftlich betrieben werden kann und andererseits zu Schichten guter Qualität führt und damit die erläuterten Nachteile des Stands der Technik überwindet.

### 3. Zusammenfassung der Erfindung

Gemäß eines ersten Aspekts betrifft die vorliegende Erfindung eine Anordnung zum kontinuiert Aufdampfen eines Hochtemperatursupraleiters auf ein Substrat im Vakuum mit einer Nachfülleinrichtung mit einem Vorrat an Hochtemperatursupraleitermaterial, einer Verdampfungseinrichtung, die das Hochtemperatursupraleitermaterial in einer Verdampfungszone mit einem Strahl eines energieübertragenden Mediums verdampft, einer Fördereinrichtung, die kontinuierlich das Hochtemperatursupraleitermaterial von der Nachfülleinrichtung zu der Verdampfungszone in einer Weise fördert, dass das zur Verdampfungszone zugeführte Hochtemperatursupraleitermaterial im wesentlichen rückstandsfrei verdampft wird und daß die Fördereinrichtung das hochtemperatur supraleiter material als Granulat mit iner korngröße von 0,05-0,5mm zu der Verdampfungszone fördert

Mit der erfindungsgemäßen Anordnung stellt sich in der Verdampfungszone ein Gleichgewicht zwischen dem kontinuierlichen Materialabtrag durch den Strahl des energieübertragenden Mediums und der kontinuierlichen Materialzufuhr durch die Fördereinrichtung ein. Da die im wesentlichen rückstandsfreie Verdampfung mit konstanter Rate (einstellbar über die Materialzufuhr) im wesentlichen im Gleichgewicht und aus einer im wesentlichen stationären Punktquelle erfolgt, wird keine komplizierte Ratenregelung benötigt und die Zusammensetzung des abgeschiedenen Films ist über die gesamte Beschichtungsfläche homogener als mit bisher bekannten Beschichtungstechniken. Zudem kann das Substrat in der erfindungsgemäßen Vorrichtung sehr nahe an die Verdampfungszone herangebracht werden und einen großen Raumwinkel abdecken, um die Ausbeute des verdampften Materials zu erhöhen. Dies ist als großer Vorteil gegenüber einer Anordnung mit mehreren Quellen (Koverdampfen, MBE) zu sehen, bei der immer ein gewisser Mindestabstand eingehalten werden muss, um Abweichungen der Zusammensetzung in Grenzen zu halten.

Bevorzugt wird der Strahl der Verdampfungseinrichtung in zumindest einer Richtung über die Verdampfungszone gescannt, wobei das von der Fördereinrichtung zur Verdampfungszone geförderte Hochtemperatursupraleitermaterial vorzugsweise zunächst vorerhitzt und dann verdampft wird.

In einer ersten bevorzugten Ausführungsform umfasst die Verdampfungseinrichtung einen vorzugsweise modulierbaren Elektronenstrahlverdampfer. Denkbar sind jedoch auch Einrichtungen zur Erzeugung anderer hochenergetischer Partikelstrahlen (z.B. Ionenbeschuss) oder die Verwendung eines Lasers. Elektronenstrahlen sind gegenwärtig bevorzugt, da sie vergleichsweise kostengünstig sind und sich gut modulieren lassen.

Bevorzugt wird das Hochtemperatursupraleitermaterialmaterial linienförmig in die Verdampfungszone gefördert, wobei die Linienform vorzugsweise eine Breite zwischen 3 und 30 mm aufweist. Das Hochtemperatursupraleitermaterial wird dabei als ein Granulat mit einer Korngröße von vorzugsweise 0,1 - 0,5 mm und besonders bevorzugt 0,1 - 0,2 mm zu der Verdampfungszone gefördert.

Granulares Schüttgut lässt sich besonderes einfach nachfüllen. Die angegebenen Parameter stellen dabei sicher, dass die Wärmekapazität der einzelnen Körner des Hochtemperatursupraleitermaterials nicht zu groß ist, und sie hinreichend schnell verdampfen. Ähnliches gilt auch wenn die Körner nicht einzeln "flashverdampft" werden, sondern über eine etwas längere Strecke x, d.h. über längere Zeit hinweg verdampft werden. Die feine Körnung ist in diesem Fall wichtig für eine ausreichende Statistik, da das Material im Einzelkorn durchaus fraktionieren kann.

Die Fördereinrichtung umfasst vorzugsweise einen drehbaren Tisch und / oder eine rotierende Walze und / oder ein Vibrationsförderer und / oder ein Förderband und / oder eine Förderschnecke oder -rutsche. Mit diesen Einrichtungen, die nur beispielhaft genannt sind, lassen sich durch entsprechend hohe Rotations- bzw. Fördergeschwindigkeiten und eine entsprechende Leistung der Verdampfereinrichtung sehr hohe Verdampfungsraten im Dauerbetrieb erzielen. Die Nachfülleinrichtung ist bevorzugt als ein Trichter ausgebildet.

Vorzugsweise wird die Fördereinrichtung gekühlt, um eine Zerstörung durch den Elektronenstrahl zu verhindern. Die Nachfülleinrichtung hingegen ist vorzugsweise geheizt und weist bevorzugt eine separate Pumpeinrichtung auf. In einem besonders bevorzugten Ausführungsbeispiel ist die Nachfülleinrichtung als ein im unteren Bereich heizbarer Trichter ausgebildet und die separate Pumpeinrichtung als ein Saugrüssel, der in den unteren Bereich hineinragt. Das bevorzugt granulare Hochtemperatursupraleitermaterial, insbesondere wenn es sich um ein hygroskopisches Material handelt, kann Wasser aufnehmen, was beim Elek-tronenbeschuss zur Explosion der Körner und damit zum Verlust des Materials aus der Verdampfungszone führt. Mit den erläuterten bevorzugten Merkmalen der Vorrichtung wird dies verhindert und darüber hinaus sichergestellt, dass das Kammervakuum nicht beeinträchtigt wird. Alternativ kann das Granulat auch thermisch vorbehandelt und entgast werden und in einer versiegelten Kartusche an die Fördereinrichtung angeflanscht werden.

Gemäß einer weiteren bevorzugen Ausführungsform weist das Hochtemperatursupraleitermaterial ein Gemisch unterschiedlicher Verbindungen auf, so dass beim Verdampfen im zeitlichen Mittel die gewünschte Zusammensetzung des Hochtemperatursupraleitermaterials abgeschieden wird, um statistische Schwankungen in der Filmzusammensetzung zu vermeiden. Ferner kann dadurch die mittlere Zusammensetzung des zu verdampfenden Hochtemperatursupraleitermaterials flexibel variiert werden, beispielsweise um eine Beeinflussung der Stöchiometrie durch unterschiedliche Haftkoeffizienten auf dem Substrat zu kompensieren. Die Mischvorrichtung kann innerhalb oder außerhalb des Vakuums angeordnet werden, oder das Material wird vorgemischt aus verschiedenen Komponenten.

Weiterhin umfasst die Anordnung vorzugsweise Mittel, die ermöglichen, in der Nähe des Substrats ein Gas abzugeben, so wie in der DE 19 680 845 C1 beschrieben. Dadurch können gasförmige Bestandteile des Hochtemperatursupraleitermaterials, die beim Verdampfen verloren gehen, kompensiert werden.

Gemäß eines weiteren Aspekts betrifft die vorliegende Erfindung ein Verfahren zum Aufdampfen einer Beschichtung aus einem Hochtemperatursupraleiter auf ein Substrat im Vakuum mit den Schritten des kontinuierlichen Zuführens eines Granulats eines Hochtemperatursupraleitermaterials in eine Verdampfungszone und des Betreibens eines Strahls eines energieübertragenden Mediums, so dass das zugeführte Granulat in der Verdampfungszone im wesentlichen rückstandsfrei verdampft wird, wobei das Hochtemperatursupraleiter material als ein Granulat mit einer korngröße vor 0,05-0,5 mm der Verdampfungszone zugeführt wird.

Vorzugsweise wird das Granulat der Verdampfungszone in Form einer Linie zugeführt, wobei der Strahl des energieübertragenden Mediums über ein Ende der Linie geführt wird, so dass die Linie im wesentlichen in ihrer ganzen Breite und über einen kleinen Bereich in Zuführrichtung gerastert wird.

Weitere Fortentwicklungen der erfindungsgemäßen Vorrichtung und des erfindungsgemäßen Verfahrens bilden den Gegenstand weiterer abhängiger Patentansprüche.

### 4. Kurze Beschreibung der Zeichnungen

Im folgenden werden bevorzugte Ausführungsbeispiele der Erfindung im Detail beschrieben mit Bezug auf die folgenden Figuren, die zeigen:
- Fig. 1:: Schemaskizze einer bevorzugten Ausführungsform der erfindungsgemäßen Vorrichtung in Aufsicht;
- Fig. 2:: Schematischer Querschnitt einer bevorzugten Ausführungsform der erfindungsgemäßen Vorrichtung mit Trichtemachfülleinrichtung;
- Fig. 3:: Schematischer Querschnitt einer bevorzugten Ausführungsform der erfindungsgemäßen Vorrichtung mit Elektronenstrahlverdampfer, Materialnachfüllung und Substrathalter;
- Fig. 4:: Schematischer Querschnitt einer bevorzugten Ausführungsform der erfindungsgemäßen Vorrichtung mit Elektronenstrahlverdampfer, Substrathalter und beheizbarem, abgepumptem Materialvorratsbehälter;

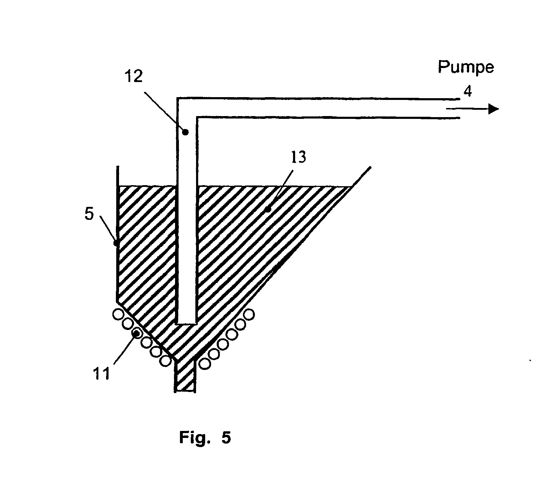

- Fig. 5:: Detaildarstellung eines beheizbaren Nachfülltrichters mit Absaugrohr;
- Fig. 6a:: Verdampfungszone der Vorrichtung (gestrichelt) am Ende der Materialspur. Die Transportrichtung ist durch den Pfeil gekennzeichnet.
- Fig. 6b:: Leistungsprofil des Elektronenstrahls in Transportrichtung x gemäß eines ersten Ausfizhrungsbeispiels;
- Fig. 6c:: Mittlere Dicke bzw. Menge D der Materialspur beim Einlauf in die Verdampfungszone;
- Fig. 7a:: Leistungsprofil des Elektronenstrahls in Transportrichtung gemäß eines weiteren bevorzugten Ausführungsbeispiels;
- Fig. 7b:: Dickenprofil D(x) des zu verdampfenden Materials in der Verdampfungszone bei Verwendung eines Leistungsprofils aus Fig. 7a.;
- Fig. 7c:: Bevorzugte Fokussierung des Elektronenstrahls für das Leistungsprofil aus Fig. 7a;
- Fig. 8a,b:: Schematische Darstellung der Verkippung der Fördereinrichtung (Fig. 8a) und des Substrats (Fig. 8b) zur Kompensation der schrägen Richtcharakteristik des verdampfenden Materials; und
- Fig. 9:: Kombination von zwei Aufdampfvorrichtungen für eine symmetrische Richtungsverteilung des verdampfenden Materials.

### 5. Detaillierte Beschreibung der Erfindung

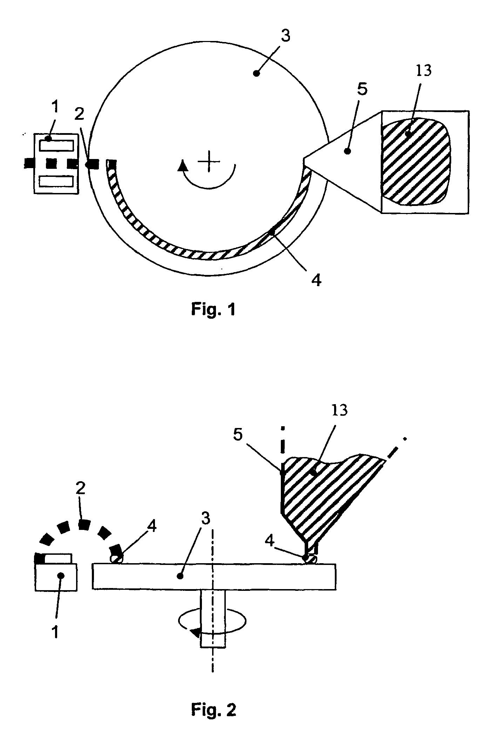

In dem in Fig. 1 gezeigten bevorzugten Ausführungsbeispiel einer erfindungsgemäßen Vorrichtung wird eine einige Millimeter bis einige Zentimeter breite Spur 4 kleingranularen Materials 13 auf eine Fördereinrichtung in Form eines gekühlten, rotierenden Tischs 3 aus gut wärmeleitendem Material, vorzugsweise Kupfer, aufgebracht und einem Elektronenstrahlverdampfer 1 zugeführt. Dazu wird das Material 13 von einem großen Reservoir durch eine kontinuierlich arbeitende Nachfülleinrichtung 5 dosiert auf der Fördereinrichtung 3 als Linie oder Spur 4 von einigen Millimetern bis einigen Zentimetern Breite aufgebracht.

Die Fördereinrichtung 3 zieht diese Linie 4 aus der Nachfülleinrichtung 5 heraus bis in die heiße Verdampfungszone eines Elektronenstrahls 2 hinein. Durch diesen wird die Linie 4 dann kontinuierlich und im wesentlichen rückstandsfrei verdampft. Der Strahl 2 kann dazu über die Linienbreite gerastert werden oder ist entsprechend breit. Durch die Rotations- bzw. Fördergeschwindigkeit der Fördereinrichtung 3 sowie den Querschnitt der Linie 4 lässt sich die Verdampfungsrate regeln. Durch entsprechend hohe Fördergeschwindigkeit und Leistung des Elektronenstrahls 2 lassen sich insbesondere auch sehr hohe Verdampfungsraten im Dauerbetrieb erzielen.

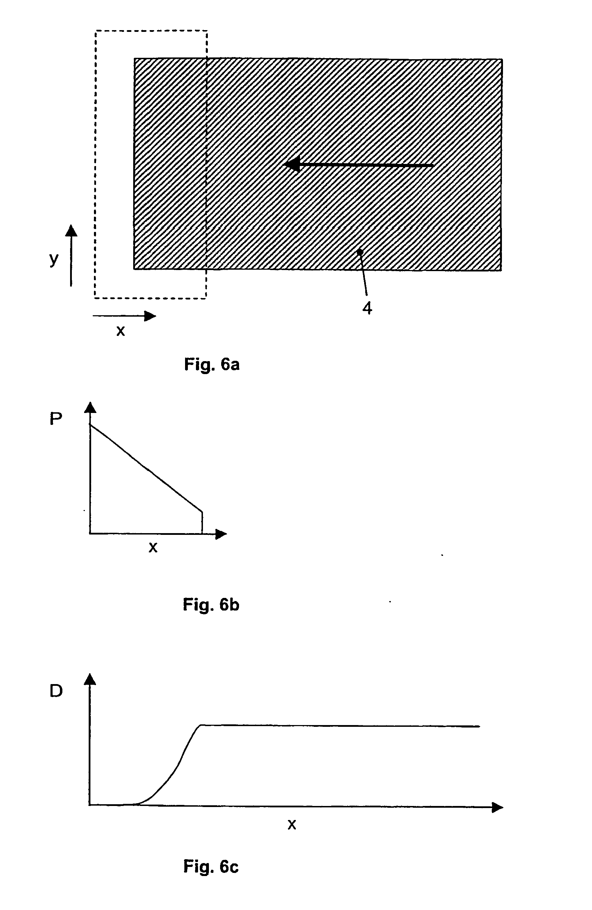

Quantitatives, d.h. im wesentlichen rückstandsfreies Verdampfen lässt sich dadurch erzielen, dass sich in einer räumlich eng begrenzten Verdampfungszone von einigen Millimetern Länge ein Gleichgewicht zwischen dem kontinuierlichen Materialabtrag durch den Elektronenstrahl 2 und der Materialzufuhr einstellt. Der Elektronenstrahl 2 kann dazu wie in Fig. 6a dargestellt, über eine Fläche (gestrichelt), die die Spitze des ankommenden Materialstroms 4 vollständig überdeckt, gerastert und auch in der Intensität moduliert werden. Moderne Elektronenstrahlverdampfer verfügen über diese Möglichkeiten.

Gemäß eines ersten Ausführungsbeispiels wird die Leistung des Elektronenstrahls 2 so moduliert (vgl. z.B. Fig. 6b), dass neu ankommendes Material zunächst mit schwächerer Leistung vorerhitzt wird und mit fortschreitendem Transport in die heiße Verdampfungszone hinein zunächst aufgeschmolzen und dann im wesentlichen vollständig verdampft wird. Am anderen Ende der Verdampfungszone sollte die Leistung P des Elektronenstrahl 2 so hoch sein, dass im wesentlichen keine Rückstände auf der Fördereinrichtung 3 zurückbleiben.

Fig. 6c zeigt den räumlichen Verlauf der mittleren Dicke D(x) der Materialspur 4 bzw. der mittleren Materialmenge in der Spur 4. Selbst wenn bei dieser Anordnung die unterschiedlichen Komponenten des Aufdampfinaterials aus unterschiedlichen Bereichen der heißen Verdampfungszone stammen, so stellt sich jedoch im kontinuierlichen Betrieb nach einer kurzen Anfangsphase ein Gleichgewicht ein, so dass im Mittel immer die durch das Aufdampfinaterial vorgegebene Zusammensetzung verdampft wird. Da die durch den Elektronenstrahl 2 überstrichene Fläche in x-Richtung der ankommenden Materialspur 4 nur eine Ausdehnung von einigen Millimetern hat, ist das Ideal einer Punktquelle in guter Näherung erfüllt.

Zur Erzielung hoher Verdampfungsraten hat es sich als vorteilhaft erwiesen, die Materiallinie 4 bis zu einige Zentimeter breit (y - Richtung) und sehr dünn aufzubringen. Dies vermeidet beim Anschmelzen des Materials 4 im Eintrittsbereich der heißen Verdampfungszone die Bildung zu großer Tröpfchen, so dass statistische Schwankungen klein bleiben.

Mit der Vorrichtung und dem Verfahren gemäß von Ausführungsbeispielen der vorliegenden Erfindung wurden oxidische Hochtemperatursupraleiterschichten des Materials YBa₂Cu₃O₇ (YBCO), DyBa₂Cu₃O₇ (DyBCO) und NdBa₂Cu₃O₇ (NdBCO) hergestellt. Die Vorrichtung und das Verfahren können jedoch auch zur Herstellung der anderen, im einleitenden Teil genannten Beschichtungen verwendet werden. Als Hochtemperatursupraleiter kommt bevorzugt allgemein RBa₂Cu₃O₇(R = Yttrium oder ein Element der Ordnungszahl 57 bis 71 oder eine Mischung dieser Elemente) in Betracht. Granulares Material mit leichtem Kupferüberschuss und mit bevorzugt 0,1 mm Korngröße wurde über einen Trichter 5 in Form einer 3 - 30 mm breiten und 0,1 - 1 mm hohen Spur 4 auf einem Kupferteller 3 aufgebracht und durch kontinuierliche Rotation von unten aus dem Trichter 5 herausgezogen und dem Elektronenstrahl 2 zugeführt. Sauerstoff wurde am ca. 680 ° C heißen Substrat 7 gezielt zugeführt, das zur Vermeidung von Schichtdickenvariationen bewegt werden kann, so dass ein epitaktischer Supraleiterfilm mit einer Abscheiderate von 0,4 nm/s deponiert wurde. Durch Anpassung der Rotationsgeschwindigkeit des Tellers 3 und der Leistung des Elektronenstrahlverdampfers 2 konnten jedoch auch ohne Probleme Bedampfungsraten von über 2 nm/s realisiert werden. Die auf MgO - Einkristallen hergestellten Supraleiterfilme zeigen Sprungtemperaturen von 87 K und kritische Stromdichten von über 2 MA/cm², was als ausgezeichnete Qualität für Anwendungen gilt.

Das zu verdampfende Granulat hat eine Korngröße zwischen 50 µm und 500 µm. Sind die Körner kleiner oder größer, so könnten sie möglicherweise, insbesondere bei höheren Verdampfungsraten mit dem Elektronenstrahl 2 versprüht werden und daher nicht richtig verdampfen. Diese Eruptionen können Materialverlust bedeuten und Abweichungen von der Stöchiometrie. Ob dies tatsächlich eintritt, hängt jedoch vom Aufbau des Gesamtsystems ab.

Die Stöchiometrie ist bei Hochtemperatur-Supraleitern besonders kritisch. Sie muss auf bevorzugt auf 1-2% genau eingehalten werden, um besonders gute Supraleitungseigenschaften reproduzieren zu können. Dies ist eine weit höhere Anforderung, als sie beispielsweise bei der Herstellung von Gläsern oder Legierungen notwendig ist. Die Wiederholfrequenz für das Raster des Elektronenstrahls 2 sollte bevorzugt so hoch wie möglich sein, vorzugsweise aber mindestens 50 Hz, um bei höheren Aufdampfraten das Versprühen des Aufdampfinaterials 4 durch Eruptionen zu minimieren.

Zur Regelung des Prozesses ist die laufende Messung der Verdampfungsrate der Hochtemperatur-Supraleiter bevorzugt. Für einen lang andauernden Beschichtungsprozess können dafür Quarz-Ratenmesser bisher nur schlecht verwendet werden, da diese schnell gesättigt werden. Stattdessen kann die Rate bevorzugt durch Atomabsorptions-Spektroskopie (AAS) gemessen werden (nicht dargestellt). Dazu muss aber mindestens eine Komponente des verdampfenden Materials 4 nicht in molekularer Form als Oxid sondern in atomarer Form als Element vorliegen.

Es hat sich herausgestellt, dass bei der Elektronenstrahl-Verdampfung von Hochtemperatursupraleitern die Komponente Cu stets in atomarer Form vorliegt. Es ist daher vorteilhaft, die gesamte Verdampfungsrate des Supraleiters durch AAS der Cu-Linie zu bestimmen. Bei den angestrebten hohen Verdampfungsraten und großen Durchmessern des Dampfstrahls für großflächige Beschichtung kann jedoch das Problem entstehen, dass die Absorptionslinie gesättigt wird. Dies kann vorteilhaft dadurch gelöst werden, dass der Dampf am Ort des zur Messung dienenden Lichtstrahls teilweise abgeschattet wird, so dass die Absorption vorzugsweise nur auf einer Mehrzahl von definierten Teilstrecken des Lichtstrahls erfolgt. Die Positionen der Teilstrecken können vorteilhaft so gewählt werden, dass die zugehörigen Dopplerverschiebungen der Cu- Absorptionslinie insgesamt die spektrale Linienbreite des Lichtstrahls überdecken. Die Längen der Teilstrecken werden vorteilhaft so gewählt, dass die Absorption bei der gewünschten Aufdampfrate ca. 30% beträgt.

Vorzugsweise werden in Kombination mit der eigentlichen Hochtemperatursupraleiterschicht auch weitere Hilfsschichten aus anderen Oxidmaterialien als Unterlage oder als Deckschichten abgeschieden. Sie dienen als Diffusionssperre, zur Erzielung einer Textur, als Keimschicht oder zum Schutz gegen Umwelteinflüsse usw. Aus technischen und aus wirtschaftlichen Gründen ist es bevorzugt, diese Schichten in situ, d. h. ohne das Vakuum zu brechen, nacheinander mit der eigentlichen Supraleiterschicht auf dem Substrat 7 aufzubringen. Daher ist es vorteilhaft, verschiedene Materialien nacheinander mit derselben Anordnung verdampfen zu können, beispielsweise indem mehrere Vorratsgefäße 5 nebeneinander auf der Fördereinrichtung 3 angeordnet werden, die jeweils an ihrem unteren Auslass verschließbar sind.

Zur Verdampfung eines bestimmten Materials wird dann eines der Vorratsgefäße 5 geöffnet und der Scanbereich des Elektronenstrahls 2 auf die zugehörige Materialspur 4 eingestellt. Der Verschluss des Vorratsgefäßes 5 am Auslass kann beispielsweise durch einen Stempel erfolgen (nicht dargestellt), der sich im Innern des Vorratsgefäßes 5 befindet. Für körniges Aufdampfgut muss der Stempel den Auslass nur versperren, nicht abdichten. Er kann also durch einen einfachen Mechanismus angehoben (Auslass offen) oder abgesenkt (Auslass geschlossen) werden. Zum Absenken muss vorzugsweise der unter dem Stempel noch vorhandene Materialrest durch Betätigen der Fördereinrichtung 3 aus dem Auslass hinausbefördert werden, bevor mit dem Verdampfen des neuen Materials begonnen wird. Bei engen Platzverhältnissen kann es auch vorteilhaft sein, die verschiedenen Vorratsgefäße 5 nicht permanent auf der Fördereinrichtung 3 anzuordnen, sondern durch einen Mechanismus jeweils nur eine Teilmenge der Vorratsgefäße, vorzugsweise nur ein einziges Vorratsgefäß 5 auf die Fördereinrichtung 3 zu setzen. Bei dem Mechanismus kann es sich beispielsweise um einen Revolver, ein Magazin oder um einzelne Absenkvorrichtungen (nicht dargestellt) für jedes Gefäß handeln.

Zur weiteren Darstellung von Abwandlungen der erfindungsgemäßen Vorrichtung und des erfindungsgemäßen Verfahrens werden im Folgenden gegenwärtig besonders bevorzugte Beispiele 1 - 8 näher erläutert:

### Beispiel 1:

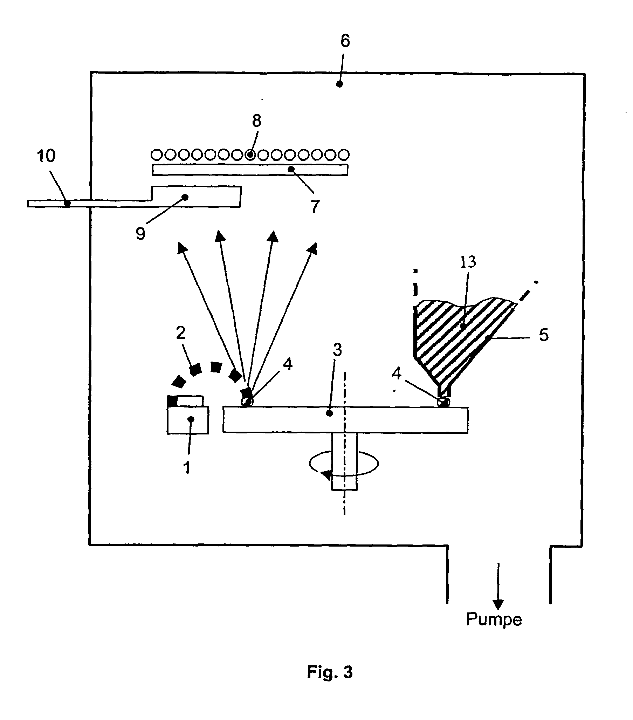

Granulares Aufdampfmaterial 13 wird über einen trapezförmig zulaufenden Trichter 5 auf den rotierbaren, wassergekühlten Kupferteller 3 eines Elektronenstrahlverdampfers 1 geleitet. Durch Rotation des Tellers 3 wird eine feine Linie des Materials 4 von unten aus dem Trichter 5 gezogen und dem Elektronenstrahl 2 auf der gegenüber liegenden Seite zugeführt. Die Leistung und Fokussierung des Elektronenstrahls 2 ist derart eingestellt, dass die ankommenden Körner des Aufdampfmaterials bei Eintritt in die heiße Verdampfungszone schnell und im wesentlichen rückstandsfrei, d.h. quantitativ verdampfen. Der Dampf breitet sich in der Hochvakuumkammer 6 ungehindert aus und schlägt sich auf einem nötigenfalls beheizten (vgl. Substratheizung 8 in Fig. 3) Substrat 7 nieder. Bei Bedarf kann auch Reaktivgas in die Kammer 6 eingelassen oder durch entsprechende Vorrichtungen 9, 10 direkt am Substrat 7 zugeführt werden.

Anders als im erläuterten Stand der Technik von Davis et al. wird dabei das Flashverdampfen als ein Einschritt-Verfahren zur Herstellung von Hochtemperatursupraleitern verwendet. Dazu wird der für die Oxidation und Kristallbildung nötige Sauerstoff direkt während der Materialabscheidung zugeführt, indem die Vorrichtung 9, 10 gemäß Fig. 3 verwendet wird und die Substrattemperatur durch den Heizer 8 erhöht wird.

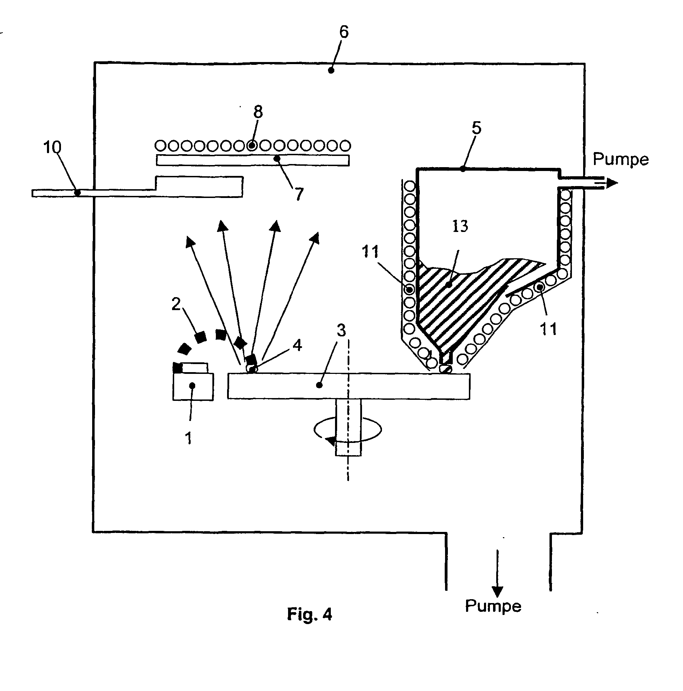

Zusätzlich kann das Flash-Verdampfen von Hochtemperatur-Supraleitern in Kombination mit einem bewegten Substrat 7 verwendet werden, beispielsweise indem das Substrat 7 in den Figuren 3 und 4 um eine vertikale Achse rotiert (nicht dargestellt). Dies hat den Vorteil einer gleichmäßigeren Stöchiometrie auf großen Flächen, die bei Hochtemperatur-Supraleitern besonders kritisch ist. Außerdem ist die Substratbewegung vorteilhaft, um ohne Unterbrechung des Aufdampfprozesses sehr viele Substrate (z. B. Wafer-Beschichtung in Serienproduktion) oder sehr große Substrate (z. B. Substratplatten für Strombegrenzer) oder sehr lange Bänder ("coated conductors") beschichten zu können, die dazu kontinuierlich durch den Aufdampfbereich transportiert werden..

### Beispiel 2:

Die Anordnung entspricht der in Beispiel 1 beschriebenen. Das Granulat 13 stammt jedoch aus einem geschlossenen, über Heizelemente 11 beheizbaren Vorratsgefäß 5, das über einen Pumpstutzen abgepumpt werden kann, um frei werdende Restgase zu entfernen. Mit dieser Anordnung wurden Aufdampfraten von 5 nm/s erreicht. Dabei wurde eine bevorzugte Korngröße von 100 bis 200 *µ*m verwendet und die bevorzugte Raster-Wiederholfrequenz war 90 Hz. Die Stöchiometrieabweichungen betrugen auf einer Fläche von 20 cm x 20 cm nur 1%.

### Beispiel 3:

Die Anordnung entspricht der in Beispiel 1 beschriebenen. Das Granulat 13 wird jedoch über einen Trichter 5 zugeführt, der nur im unteren Auslassbereich durch Heizelemente 11 beheizt wird. Der dabei frei werdende Wasserdampf wird direkt am Entstehungsort über ein Saugrohr 12 , vorteilhaft mit einem Siebvorsatz am Einlass (nicht dargestellt), abgepumpt.

### Beispiel 4:

Granulares Aufdampfmaterial 13 wird über ein Förderband, eine Förderschnecke oder eine ähnliche Fördereinrichtung wie über eine Rutsche (nicht dargestellt) auf den rotierbaren, wassergekühlten Kupferteller 3 eines Elektronenstrahlverdampfers geleitet. Durch die Rotation des Tellers 3 wird eine feine Linie des Materials 4 dem Elektronenstrahl 2 auf der gegenüberliegenden Seite zugeführt. Die Leistung und Ausdehnung des Elektronenstrahls 2 ist derart eingestellt, dass die ankommenden Körner des Aufdampfinaterials 13 bei Eintritt in die heiße Zone schnell und im wesentlichen rückstandsfrei, d.h. quantitativ verdampfen. Der Dampf breitet sich in der Hochvakuumkanuner 6 ungehindert aus und schlägt sich auf einem gegebenenfalls mit einer Substratheizung 8 versehenen Substrat 7 nieder. Bei Bedarf kann auch Reaktivgas in die Kammer eingelassen oder durch entsprechende Vorrichtungen 9, 10 direkt am Substrat 7 zugeführt werden.

### Beispiel 5:

Granulares Aufdampfimaterial 13 wird über eine Nachfülleinrichtung, z.B. einen trapezförmig zulaufenden Trichter 5, auf eine rotierende, wassergekühlten Walze (nicht dargestellt) aufgebracht und als feine Linie dem Elektronenstrahl 2 eines Elektronenstrahlverdampfers zugeführt. Die Leistung und Fokussierung des Elektronenstrahls ist derart eingestellt, dass die ankommenden Körner des Aufdampfmaterials bei Eintritt in die heiße Zone schnell und im wesentlichen rückstandsfrei, d.h. quantitativ verdampfen. Der Dampf breitet sich in der Hochvakuumkammer 6 ungehindert aus und schlägt sich auf einem gegebenenfalls mit einer Substratheizung 8 versehenen Substrat 7 nieder. Bei Bedarf kann auch Reaktivgas in die Kammer eingelassen oder durch entsprechende Vorrichtungen 9, 10 direkt am Substrat 7 zugeführt werden.

### Beispiel 6:

Granulares Aufdampfmaterial 13 wird über eine Nachfülleinrichtung, z.B. einen trapezförmig zulaufenden Trichter 5, auf einen wassergekühlten Vibrationsförderer aufgebracht und als feine Linie dem Elektronenstrahl 2 eines Elektronenstrahlverdampfers 1 zugeführt. Die Leistung und Fokussierung des Elektronenstrahls ist derart eingestellt, dass die ankommenden Körner des Aufdampfmaterials bei Eintritt in die heiße Zone schnell und rückstandsfrei, d.h. quantitativ verdampfen. Der Dampf breitet sich in der Hochvakuumkammer 6 ungehindert aus und schlägt sich auf einem gegebenenfalls mit einer Substratheizung 8 versehenen Substrat 7 nieder. Bei Bedarf kann auch Reaktivgas in die Kammer 6 eingelassen oder durch entsprechende Vorrichtungen 9, 10 direkt am Substrat 7 zugeführt werden.

### Beispiel 7:

Granulares Aufdampfinaterial 13 wird über eine Nachfülleinrichtung, z.B. einen trapezförmig zulaufenden Trichter 5, auf ein gekühltes Förderband aufgebracht und als feine Linie dem Elektronenstrahl 2 eines Elektronenstrahlverdampfers zugeführt. Die Leistung und Fokussierung des Elektronenstrahls ist derart eingestellt, dass die ankommenden Körner des Aufdampfmaterials bei Eintritt in die heiße Zone schnell und rückstandsfrei, d.h. quantitativ verdampfen. Der Dampf breitet sich in der Hochvakuumkammer 6 ungehindert aus und schlägt sich auf einem gegebenenfalls mit einer Substratheizung 8 versehenen Substrat 7 nieder. Bei Bedarf kann auch Reaktivgas in die Kammer eingelassen oder durch entsprechende Vorrichtungen 9, 10 direkt am Substrat 7 zugeführt werden.

### Beispiel 8:

Materialzufuhr und Transport entsprechen einem der vorangegangenen Beispiele 1- 7. Die Materialspur 4 kann eine Breite von mehreren Zentimetern aufweisen. Der Elektronenstrahl 2 wird über eine Fläche, die die Breite der ankommenden Materialspur 4 vollständig überdeckt, z.B. eine rechteckige Fläche wie in Fig. 6a dargestellt, gerastert. Dabei wird die Leistung P des Elektronenstrahls 2 so moduliert, dass das ankommende Material mit fortschreitender Position zunächst vorerhitzt, angeschmolzen und dann vollständig verdampft wird. Ein geeignetes Leistungsprofil ist beispielsweise in Fig. 6b dargestellt. Die Form des Profils (z.B. linear, exponentiell, sinusförmig, etc.) kann dabei geeignet gewählt werden. Wichtig ist in diesem Zusammenhang hauptsächlich, dass die Spitzenleistung hoch genug gesetzt wird, so dass das gesamte Material im wesentlichen rückstandsfrei verdampft. In diesem Fall kann sich z.B. ein Dickenprofil der Materialspur wie in Fig. 6c gezeigt einstellen.

### Beispiel 9:

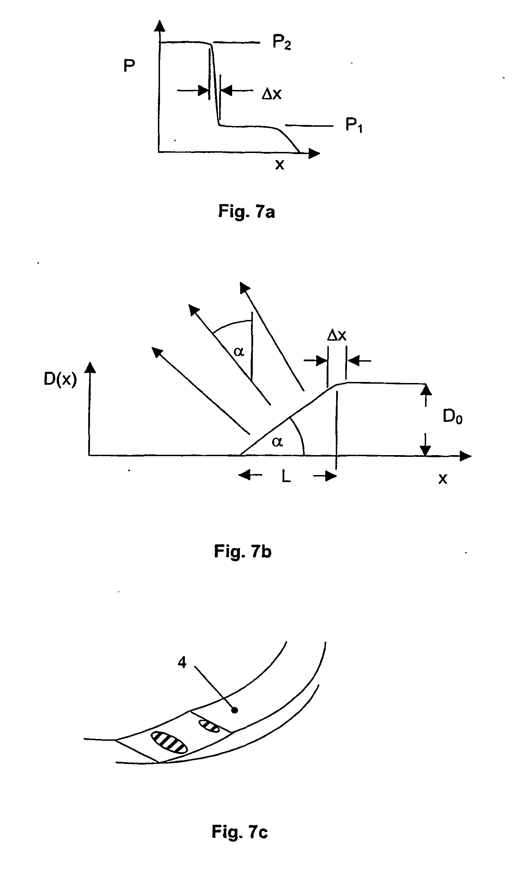

Gemäß einem weiteren Ausführungsbeispiel wird ein vorteilhaftes 2-Stufenprofil mit im Wesentlichen zwei Leistungsstufen für den Elektronenstrahl 2 verwendet, das in Fig. 7a dargestellt ist. Dabei wird die Leistungsstufe P₁ vorzugsweise so gewählt, dass das Material zwar ausgeheizt wird, aber die Temperatur noch nicht ausreicht, um Bestandteile des Hochtemperatursupraleiters, insbesondere Cu, zu verdampfen. Die Leistungsstufe P₂ wird bevorzugt so gewählt, dass der Hochtemperatursupraleiter quantitativ verdampft wird. Die Übergangsbreite Δx zwischen beiden Zonen ist vorzugsweise möglichst scharf, damit das Material sofort quantitativ verdampft. Dann stellt sich eine lineare Abfallflanke des Dickenprofils D(x) gemäß Fig. 7b ein.

Ist die Übergangsbreite Δx zwischen den beiden Leistungszonen nicht hinreichend scharf, besteht die Gefahr, dass die Oberkante der Abfallflanke (d. h. die Grenze zwischen den beiden Leistungszonen) verrundet wird und insbesondere der Cu-Anteil des Granulats mit falscher Richtcharakteristik verdampft. Um einen scharfen Übergang zu erreichen, muss der Elektronenstrahl bevorzugt so fokussiert werden, dass er während der Rasterung die kleinstmögliche Breite erreicht, wenn er sich gerade an der Oberkante der Flanke befindet. Dies ist in Fig. 7c schematisch dargestellt.

Der Abfallwinkel α der Flanke in Fig. 7b bestimmt sich durch die Fördergeschwindigkeit des Aufdampfgutes V_{F} und die Verdampfungsgeschwindigkeit der Materialspur dD/dt gemäß tan α = (dD/dt)/V_{F}. Damit lässt sich der Winkel α für jede Verdampfungsgeschwindigkeit durch die Fördergeschwindigkeit einstellen.

Da das Aufdampfgut bevorzugt von der Flanke abdampft, ist die Richtcharakteristik des abdampfenden Materials um den Winkel α gegen die Normalenrichtung der Fördereinrichtung gekippt (siehe Figur Fig. 7b). Die Kippung ist in den meisten Fällen für die Beschichtung ungünstig. Daher sollte α vorteilhaft nicht größer als 20° sein. Wird andererseits der Winkel α zu flach, so wächst bei vorgegebener Anfangsdicke D₀ der Materialspur die Länge der Verdampfungszone L gemäß L = D₀/tan α. Vorteilhaft sollte L nicht mehr als 10 mm betragen, damit das Material genügend punktförmig verdampft und keine merklichen Stöchiometriegradienten auf dem Substrat entstehen. Bei einer typischen Dicke D₀ = 1 mm sollte α also vorzugsweise nicht kleiner als 6° sein.

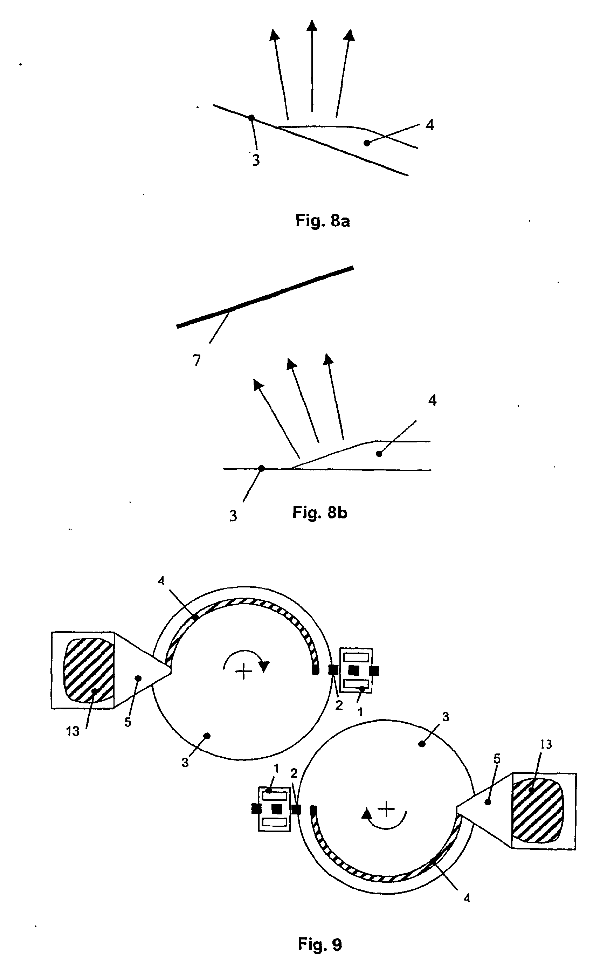

Die Kippung der Richtkeule des verdampfenden Materials um den Winkel α kann dadurch kompensiert werden, dass die Fördereinrichtung 3 mitsamt der Förderspur 4 insgesamt um im wesentlichen denselben Winkel entgegengesetzt gekippt wird. Dies ist in Fig. 8a. schematisch dargestellt. Bei zu großem Kippwinkel kann dabei allerdings die Förderung des Aufdampfgutes behindert werden, wenn die Spur 4 auf der Fördereinrichtung 3 ins Rutschen kommt. Dieses Problem wird bei einer weiteren Möglichkeit, den Winkel α zu kompensieren, vermieden, indem das Substrat 7 entsprechend schräg gestellt wird. Dies ist in Fig. 8b schematisch dargestellt.

### Beispiel 10:

Um trotz der Verkippung um den Winkel α zu einer symmetrischen Richtungsverteilung des verdampfenden Materials zu kommen, können gemäß einem weiteren Ausführungsbeispiel auch zwei oder mehr Aufdampfvorrichtungen verwendet werden. Z. B. lassen sich zwei Aufdampfvorrichtungen vorteilhaft so nebeneinander anordnen, dass sich die Verdampfungszonen und die beiden Abfallflanken direkt gegenüber stehen. Dies ist in Fig. 9 dargestellt. Die Verdampfungsraten beider Vorrichtungen sollten dabei bevorzugt übereinstimmen.

### Bezugszeichenliste:

- 1: Elektronenkanone
- 2: Elektronenstrahl
- 3: Teller (drehbar)
- 4: Materialspur (Linie)
- 5: Nachfülleinrichtung, (Trichter, Vorratsgefäß)
- 6: Vakuumkammer
- 7: Substrat
- 8: Substratheizung
- 9: Reaktionsgasversorgung
- 10: Gaseinlass
- 11: Heizelement
- 12: Saugrohr
- 13: Granulat

## Patentansprüche

1. Anordnung zum kontinuierlichen Aufdampfen eines Hochtemperatursupraleiters (13) auf ein Substrat (7) im Vakuum (6), aufweisend:
a. eine Nachfülleinrichtung (5) mit einem Vorrat an Hochtemperatursupraleitermaterial (13);
b. eine Verdampfungseinrichtung (1), die das Hochtemperatursupraleitermaterial (13) in einer Verdampfungszone mit einem Strahl (2) eines energieübertragenden Mediums verdampft;
c. eine Fördereinrichtung (3), die kontinuierlich das Hochtemperatursupraleitermaterial (13) von der Nachfülleinrichtung (5) zu der Verdampfungszone in einer Weise fördert, dass das zur Verdampfungszone zugeführte Hochtemperatursupraleitermaterial (13) im wesentlichen rückstandsfrei verdampft wird, **dadurch gekennzeichnet, dass**
d. die Fördereinrichtung das Hochtemperatursupraleitermaterial (13) als ein Granulat (13) mit einer Korngröße von 0,05 - 0,5 mm zu der Verdampfungszone fordert.

2. Anordnung nach Anspruch 1, ferner aufweisend Mittel um den Strahl (2) der Verdampfungseinrichtung (1) in zumindest einer Richtung über die Verdampfungszone zu scannen.

3. Anordnung nach Anspruch 2, wobei die Mittel den Strahl (2) mit einer Wiederholfrequenz > 50 Hz, bevorzugt ca. 90 Hz scannen.

4. Anordnung nach einem der Ansprüche 1 - 3, ferner aufweisend Mittel, um das von der Fördereinrichtung (3) zur Verdampfungszone geförderte Hochtemperatursupraleitermaterial (13) zunächst vorzuerhitzen und dann zu verdampfen.

5. Anordnung nach Anspruch 4, wobei die Verdampfungseinrichtung zumindest zwei Leistungsstufen (P₁, P₂) für den Strahl (2) aufweist, vorzugsweise mit einem scharfen Übergang (Δx) von der ersten zur zweiten Leistungsstufe, um eine lineare Abfallflanke des Dickenprofils D(x) des geförderten Hochtemperatursupraleitermaterials (13) zu erzielen.

6. Anordnung nach Anspruch 5, wobei die Fördergeschwindigkeit der Fördereinrichtung (3) so einstellbar ist, dass der Winkel der Abfallflanke a < 20° ist und / oder die Länge der Verdampfungszone < 10 mm ist.

7. Anordnung nach einem der Ansprüche 5 oder 6, wobei der Strahl (2) des energieübertragenden Mediums so fokussierbar ist, dass er während der Rasterung die kleinstmögliche Breite erreicht, wenn er sich im wesentlichen an der Oberkante der Abfallflanke befindet.

8. Anordnung nach einem der Ansprüche 1 - 7, wobei die Fördereinrichtung (3) und / oder das Substrat (7) verkippbar sind, um eine verkippte Richtcharakteristik des von der Fördereinrichtung (3) abdampfenden Materials zu kompensieren.

9. Anordnung nach einem der Ansprüche 1 - 8, wobei die Verdampfungseinrichtung (1) einen vorzugsweise modulierbaren Elektronenstrahlverdampfer (1) umfasst.

10. Anordnung nach einem der Ansprüche 1-9, wobei das Hochtemperatursupraleitermaterial (13) linienförmig mit einer Breite von vorzugsweise zwischen 3 und 30 mm in die Verdampfungszone gefördert wird.

11. Anordnung nach einem der Ansprüche 1-10, wobei die Fördereineinrichtung das Hochtemperatursupraleitermaterial (13) als ein Granulat (13) mit einer Korngröße von 0,1 - 0,2 mm zu der Verdampfungszone fördert.

12. Anordnung nach einem der Ansprüche 1- 11, wobei die Fördereinrichtung (3) kühlbar ist und einen drehbaren Tisch und / oder eine rotierende Walze und / oder einen Vibrationsförderer und / oder ein Förderband und / oder eine Förderschnecke oder -rutsche umfasst.

13. Anordnung nach einem der Ansprüche 1 - 12, wobei die Nachfülleinrichtung als ein Trichter (5) ausgebildet ist und / oder geheizt ist.

14. Anordnung nach Anspruch einem der Ansprüche 1 - 13, wobei die Nachfülleinrichtung (5) eine separate Pumpeinrichtung (12) aufweist.

15. Anordnung nach Anspruch 14, wobei die Nachfülleinrichtung (5) als ein im unteren Bereich heizbarer Trichter (5) ausgebildet ist und die separate Pumpeinrichtung (12) als ein Saugrüssel (12) ausgebildet ist, der in den unteren Bereich des Trichters (5) hineinragt.

16. Anordnung nach einem der vorhergehenden Ansprüche, wobei das Hochtemperatursupraleitermaterial (13) ein Gemisch unterschiedlicher Verbindungen aufweist, so dass beim Verdampfen im zeitlichen Mittel die gewünschte Zusammensetzung des Hochtemperatursupraleitermaterials (13) abgeschieden wird.

17. Anordnung nach einem der vorhergehenden Ansprüche, ferner aufweisend Mittel (9, 10), die ermöglichen in der Nähe des Substrats (7) ein Gas, vorzugsweise Sauerstoff, abzugeben.

18. Anordnung nach einem der vorhergehenden Ansprüche, ferner aufweisend Mittel (8), um das Substrat (7) zu heizen und / oder relativ zur Verdampfungszone zu bewegen.

19. Anordnung nach einem der vorhergehenden Ansprüche, ferner aufweisend Mittel zum Messen der Verdampfungsrate durch Atomabsorptionsspektroskopie, vorzugsweise einer Cu-Linie des verdampfenden Hochtemperatursupraleitermaterials.

20. Anordnung nach Anspruch 19, ferner aufweisend Mittel, um den Dampf des Hochtemperatursupraleitermaterials am Ort des zur Messung dienenden Lichtstrahls teilweise abzuschatten, um eine Sättigung der Absorptionslinie zu vermeiden.

21. Anordnung nach einem der vorhergehenden Ansprüche, ferner aufweisend zumindest eine weitere Nachfülleinrichtung mit Ausgangsmaterial für eine Hilfsschicht der Hochtemperatursupraleiterschicht.

22. Anordnung nach Anspruch 21, ferner aufweisend Mittel, um die zumindest eine weitere Nachfülleinrichtung und die Nachfülleinrichtung (5) zur Aufnahme eines Vorrats an Hochtemperatursupraleitermaterial (13) nacheinander mit der Fördereinrichtung (3) zu verbinden.

23. Verfahren zum Aufdampfen einer Beschichtung aus einem Hochtemperatursupraleiter auf ein Substrat (7) im Vakuum (6), aufweisend:
a. kontinuierliches Zuführen eines Granulats (13) eines Hochtemperatursupraleitermaterials in eine Verdampfungszone; und
b. Betreiben eines Strahls (2) eines energieübemagenden Mediums, so dass das zugeführte Granulat (13) in der Verdampfungszone im wesentlichen rückstandsfrei verdampft wird, **dadurch gekennzeichnet, dass**
c. das Hochtemperatursupraleitermaterial (13) als ein Granulat (13) mit einer Korngröße von 0,05 - 0,5 mm der Verdampfungszone zugeführt wird.

24. Verfahren nach Anspruch 23, wobei das Granulat (13) der Verdampfungszone in Form einer Linie (4) zugeführt wird.

25. Verfahren nach Anspruch 24 wobei der Strahl (2) des energieübertragenden Mediums über ein Ende der Linie (4) geführt wird, so dass die Linie (4) im wesentlichen in ihrer ganzen Breite und über einen kleinen Bereich in Zufiihrrichtung gerastert wird.

26. Verfahren nach einem der Ansprüche 23 - 25, wobei der Hochtemperatursupraleiter RBa₂Cu₃O₇ (R = Yttrium oder ein Element der Ordnungszahl 57 bis 71 oder eine Mischung dieser Elemente) ist.

27. Verfahren nach einem der Ansprüche 23 - 26 unter Verwendung einer Anordnung nach einem der Ansprüche 1 - 22.

## Claims

1. Device for continuous evaporation of a high temperature superconductor (13) onto a substrate (7) in vacuum (6) comprising:
a. a refilling device (5) with a stock of high temperature superconductor material (13);
b. an evaporation device (1) which evaporates the high temperature superconductor material (13) in an evaporation zone by a beam (2) of an energy transferring medium;
c. a conveyor (3) which continuously transports the high temperature superconductor material (13) from the refilling device (5) to the evaporation zone in a way that the high temperature superconductor material (13) delivered to the evaporation zone is evaporated essentially without residues, **characterized in that**
d. the conveyor transports the high temperature superconductor material (13) to the evaporation zone as a granulate (13) with a grain size of 0.05 - 0.5 mm.

2. Device according to claim 1, further comprising means to scan the beam (2) of the evaporator (1) in at least one direction over the evaporation zone.

3. Device according to claim 2, wherein the means are scanning the beam (2) at a repetition frequency > 50 Hz, preferably at about 90 Hz.

4. Device according to one of the claims 1 - 3, further comprising means to first pre-heat and then evaporate the high temperature superconductor material (13) delivered to the evaporation zone by the conveyor (3).

5. Device according to claim 4, where the evaporation device comprises at least two power levels (P₁,P₂) for the beam (2), preferably with a narrow transition width (Δx) between the first and the second power level to achieve a linear slope of the thickness profile D(x) of the delivered high temperature superconductor material (13).

6. Device according to claim 5, wherein the conveying speed of the conveyor (3) can be adjusted such that the angle of the slope α is < 20° and / or the length of the evaporation zone is < 10 mm.

7. Device according to one of the claims 5 or 6, wherein the beam (2) of the energy transferring medium can be focused in such a way that while scanning it reaches its minimum width when it is located essentially at the upper edge of the slope.

8. Device according to one of the claims 1 - 7, wherein the conveyor (3) and /or the substrate (7) can be tilted to compensate for an inclined directional characteristic of the material evaporating from the conveyer (3).

9. Device according to one of the claims 1 - 8, wherein the evaporation device (1) comprises an electron beam evaporator (1) which can be preferably modulated.

10. Device according to one of the claims 1 - 9, wherein the high temperature superconductor material (13) is conveyed into the evaporation zone in the shape of a line with a width preferably between 3 and 30 mm.

11. Device according to one of the claims 1 ― 10, wherein the conveyor transports the high temperature superconductor material (13) to the evaporation zone as a granulate (13) with a grain size of 0.1 - 0.2 mm.

12. Device according to one of the claims 1 - 11, wherein the conveyor (3) can be cooled and comprises a rotating turntable and / or a rotating drum and /or a vibration conveyor and / or a conveyor belt and / or a screw conveyor or slide.

13. Device according to one of the claims 1 - 12, wherein the refilling device is designed as a funnel (5) and / or can be heated.

14. Device according to one of the claims 1 - 13, wherein the refilling device (5) has a separate pumping device (12).

15. Device according to claim 14, wherein the refilling device (5) is designed as a funnel (5) which can be heated in the bottom section, and the separate pumping device (12) is designed as a suction pipe (12) which protrudes into the bottom section of the funnel (5).

16. Device according to one of the previous claims, wherein the high temperature superconductor material (13) is a mixture of different compounds so that upon evaporation on temporal average the desired composition of the high temperature superconductor material (13) is deposited.

17. Device according to one of the previous claims, further comprising means (9, 10) which enable to supply a gas, preferably oxygen, close to the substrate (7).

18. Device according to one of the previous claims, further comprising means (8) to heat and / or to move the substrate (7) relative to the evaporation zone.

19. Device according to one of the previous claims, further comprising means to measure the evaporation rate by atomic absorption spectroscopy, preferably of a Cu-line of the evaporating high temperature superconductor material.

20. Device according to claim 19, further comprising means to partially shade the vapor of the high temperature superconductor material at the location of the measuring light beam to avoid saturation of the absorption line.

21. Device according to one of the previous claims, further comprising at least another refilling device with source material for an auxiliary layer of the high temperature superconductor film.

22. Device according to claim 21, further comprising means to connect at least another refilling device and the refilling device (5) for holding a stock of high temperature superconductor material (13) sequentially with the conveyor (3).

23. Method for evaporating a high temperature superconductor coating onto a substrate (7) in vacuum (6) comprising the steps of:
a. continuously conveying a granulate (13) of a high temperature superconductor material into an evaporation zone; and
b. operating a beam (2) of an energy transferring medium, so that the delivered granulate (13) is evaporated essentially without residues within the evaporation zone, **characterized in that**
c. the high temperature superconductor material (13) is conveyed to the evaporation zone as granulate (13) with a grain size of 0.05 - 0.5 mm.

24. Method according to claim 23, wherein the granulate (13) is conveyed to the evaporation zone in the shape of a line (4).

25. Method according to claim 24, wherein the beam (2) of the energy transferring medium is guided over one end of the trace (4) so that the trace (4) is scanned essentially across its entire width and over a small section in the direction of the conveying motion.

26. Method according to one of the claims 23 - 25, wherein the high temperature superconductor is RBa₂Cu₃O₇ (R = yttrium, or an element with atomic number 57 to 71, or a mixture of these elements).

27. Method according to one of the claims 23 - 26, using a device according to claims 1 - 22.

## Revendications

1. Installation destinée au dépôt continu en phase vapeur sous vide (6) d'un supraconducteur à haute température (13) sur un substrat (7), comportant :
a. un dispositif de remplissage (5) avec une réserve de matériau supraconducteur à haute température (13) ;
b. un dispositif de vaporisation (1), qui vaporise le matériau supraconducteur à haute température (13) dans une zone de vaporisation avec un jet (2) d'un milieu transmettant de l'énergie ;
c. un dispositif de transport (3), qui transporte le matériau supraconducteur à haute température (13) en continu du dispositif de remplissage (5) vers la zone de vaporisation de telle sorte que le matériau supraconducteur à haute température (13) amené à la zone de vaporisation soit pour l'essentiel vaporisé sans résidus, **caractérisée en ce que**
d. le dispositif de transport transporte le matériau supraconducteur à haute température (13) vers la zone de vaporisation à l'état de granulat (13) d'une granulométrie de 0,05 à 0,5 mm.

2. Installation selon la revendication 1, comportant par ailleurs des moyens pour scanner le jet (2) du dispositif de vaporisation (1) au-dessus de la zone de vaporisation dans au moins une direction.

3. Installation selon la revendication 2, dans laquelle les moyens scannent le jet (2) avec une fréquence de répétition > 50 Hz, de préférence de l'ordre de 90 Hz.

4. Installation selon l'une quelconque des revendications 1 à 3, comportant par ailleurs des moyens pour préchauffer dans un premier temps le matériau supraconducteur à haute température (13) amené par le dispositif de transport (3) vers la zone de vaporisation, et pour le vaporiser ensuite.

5. Installation selon la revendication 4, dans laquelle le dispositif de vaporisation comporte au moins deux niveaux de puissance (P₁, P₂) pour le jet (2), de préférence avec une transition raide (Δx) du premier au deuxième niveau de puissance, afin d'obtenir un flanc de retombée linéaire du profil d'épaisseur D(x) du matériau supraconducteur à haute température (13) transporté.

6. Installation selon la revendication 5, dans laquelle la vitesse de transport du dispositif de transport (3) est réglable de telle sorte que l'angle α du flanc de retombée soit < 20° et/ou que la longueur de la zone de vaporisation soit < 10 mm.

7. Installation selon l'une des revendications 5 ou 6, dans laquelle le jet (2) du milieu transmettant de l'énergie peut être focalisé de telle sorte qu'il atteigne pendant le balayage la largeur minimale possible lorsqu'il se trouve sensiblement au niveau du bord supérieur du flanc de retombée.

8. Installation selon l'une quelconque des revendications 1 à 7, dans laquelle le dispositif de transport (3) et/ou le substrat (7) peuvent être basculés afin de compenser une caractéristique directive basculée du matériau se vaporisant à partir du dispositif de transport (3).

9. Installation selon l'une quelconque des revendications 1 à 8, dans laquelle le dispositif de vaporisation (1) comporte un vaporisateur à jet d'électrons (1) qui est de préférence modulable.

10. Installation selon l'une quelconque des revendications 1 à 9, dans laquelle le matériau supraconducteur à haute température (13) est transporté dans la zone de vaporisation sous forme de lignes, d'une largeur qui est de préférence comprise entre 3 et 30 mm.

11. Installation selon l'une quelconque des revendications 1 à 10, dans laquelle le dispositif de transport transporte le matériau supraconducteur à haute température (13) vers la zone de vaporisation à l'état de granulat (13) d'une granulométrie de 0,1 à 0,2 mm.

12. Installation selon l'une quelconque des revendications 1 à 11, dans laquelle le dispositif de transport (3) peut être refroidi, et comporte une table rotative et/ou un cylindre rotatif et/ou un transporteur vibrant et/ou une bande transporteuse et/ou une vis ou une goulotte de transport.

13. Installation selon l'une quelconque des revendications 1 à 12, dans laquelle le dispositif de remplissage est agencé sous la forme d'une trémie (5) et/ou est chauffé.

14. Installation selon l'une quelconque des revendications 1 à 13, dans laquelle le dispositif de remplissage (5) comporte un dispositif de pompage (12) séparé.

15. Installation selon la revendication 14, dans laquelle le dispositif de remplissage (5) est agencé sous la forme d'une trémie (5) pouvant être chauffée dans la zone inférieure, et le dispositif de pompage (12) séparé est agencé sous la forme d'une trompe d'aspiration (12) qui pénètre dans la zone inférieure de la trémie (5).

16. Installation selon l'une quelconque des revendications précédentes, dans laquelle le matériau supraconducteur à haute température (13) est un mélange de différents composés, de sorte que, lors de la vaporisation, la composition souhaitée du matériau supraconducteur à haute température (13) soit déposée en moyenne dans le temps.

17. Installation selon l'une quelconque des revendications précédentes, comportant par ailleurs des moyens (9, 10) qui permettent de délivrer un gaz, de préférence de l'oxygène, à proximité du substrat (7).

18. Installation selon l'une quelconque des revendications précédentes, comportant par ailleurs des moyens (8) pour chauffer le substrat (7) et/ou le déplacer par rapport à la zone de vaporisation.

19. Installation selon l'une quelconque des revendications précédentes, comportant par ailleurs des moyens pour mesurer le taux de vaporisation par spectroscopie d'absorption atomique, de préférence d'une ligne de Cu du matériau supraconducteur à haute température se vaporisant.

20. Installation selon la revendication 19, comportant par ailleurs des moyens pour shunter partiellement la vapeur du matériau supraconducteur à haute température au niveau de l'emplacement du rayon lumineux servant à la mesure, afin d'éviter une saturation de la ligne d'absorption.

21. Installation selon l'une quelconque des revendications précédentes, comportant par ailleurs au moins un autre dispositif de remplissage avec du matériau de départ destiné à une couche auxiliaire de la couche de matériau supraconducteur à haute température.

22. Installation selon la revendication 21, comportant par ailleurs des moyens pour relier successivement au dispositif de transport (3) l'au moins un autre dispositif de remplissage et le dispositif de remplissage (5) destinés à la réception d'une réserve de matériau supraconducteur à haute température (13).

23. Procédé destiné au dépôt en phase vapeur sous vide (6) d'un revêtement constitué d'un supraconducteur à haute température sur un substrat (7), comportant :
a. l'amenée continue d'un granulat (13) d'un matériau supraconducteur à haute température dans une zone de vaporisation ; et
b. le fonctionnement d'un jet (2) d'un milieu transmettant de l'énergie, de sorte que le granulat (13) amené soit pour l'essentiel vaporisé sans résidus dans la zone de vaporisation, **caractérisé en ce que**
c. le matériau supraconducteur à haute température (13) est amené dans la zone de vaporisation à l'état de granulat (13) d'une granulométrie de 0,05 à 0,5 mm.

24. Procédé selon la revendication 23, avec lequel le granulat (13) est amené à la zone de vaporisation sous la forme d'une ligne (4).

25. Procédé selon la revendication 24, avec lequel le jet (2) du milieu transmettant de l'énergie est guidé au-dessus d'une extrémité de la ligne (4), de sorte que la ligne (4) soit pour l'essentiel balayée sur la totalité de sa largeur et sur une petite zone dans la direction d'amenée.

26. Procédé selon l'une quelconque des revendications 23 à 25, dans lequel le supraconducteur à haute température est du RBa₂Cu₃O₇ (R = de l'yttrium ou un élément du nombre atomique 57 à 71, ou un mélange de ces éléments).

27. Procédé selon l'une quelconque des revendications 23 à 26 avec utilisation d'une installation selon l'une quelconque des revendications 1 à 22.
